# EUROPEAN PATENT APPLICATION

(11) **EP 2 797 232 A1**
(43) Date of publication of application: **29.10.2014**
(21) Application number: 13165406.3
(22) Date of filing: 25.04.2013
(51) Int. Cl.: H03F 3/60, H03F 1/02, H03F 1/30

(54) **A solid-state RF power amplifier system**

(71) Applicant: Paul Scherrer Institut, 5232 Villigen (CH)
(72) Inventor: Gaspar, Marcos Andrö, 8046 Zürich (CH)
(74) Representative: Fischer, Michael

(57) **Abstract**

The combination efficiency and the overall efficiency of a high power RF amplifier composed of a number of RF amplifier modules (16) are improved by adjusting the output power and the phase delay of each RF amplifier module (16). The input forward power, output forward power and output reflected power of each RF amplifier module are monitored. The output power of each RF amplifier module (16) is adjusted so that the combining efficiency is maximized. An extra optimization is performed so that the overall efficiency is maximized. The high power amplifier can operate at maximum combining and overall efficiency at any required output power.

## Description

The present invention relates to a solid-state RF power amplifier system, such as for use with accelerator applications. In particular, the present invention relates to efficiency optimization of combined high power solid state RF amplifiers for accelerator and physics applications.The efficiencyimprovementproposed bythisinvention allows high power combined amplifiers to have better efficiency than vacuum tubes used at similar frequency ranges.

The past few years have seen considerable progress in the performance of semiconductors for high power CW applications. More specifically, in the UHF frequency range which is of particular interest for synchrotron light sources. Initially, MOSFET's succeeded to reach 250W output power at frequencies up to 250 MHz. Those transistors could be pushed to 352 MHz while still offering satisfactory performance. Later LDMOS were also able to work satisfactorily up to the same frequency range but offering better reliability. Those were the first devices really useful and competitive for 500 MHz accelerator applications. More recently, improvements in LDMOS technology resulted in new transistors for cellular, DVB-T applications and UHF that can now reliably deliver more than 500W CW output power at a reasonable price. After preliminary laboratory tests, the BLF578 transistor from NXP has been chosen for the target applications since this type of transistor was the best available at the time of the present design. As the authors expect further evolution in the LDMOS transistor technology and consequent improvement in reliability, efficiency, maximum output power per device, and reduction in the price per watt, one can foresee an increase in the competitiveness and consequent increase in use of SSPA in high power accelerator applications. In addition, the slow decrease in availability and increase in the price of high power RF tubes suggests that it could be wise to increase the efforts on the further development of SSPA.

The current invention is based on the work which has been performed for applications to the Swiss Light Source (SLS) at the Paul Scherrer Institute (Switzerland). The SLS is an accelerator complex composed of three accelerators, a 100 MeV linac, a 2.4 GeV booster synchrotron and a 2.4 GeV 400 mA electron storage ring. The main purpose of this facility is to generate X-rays with a broad spectral range which is useful in several research areas, such as study of magnetic properties of surfaces, determination of structures of protein crystals for the development of new drugs and to understand the human genome, study of surfaces with low friction, high temperature superconductors, high resolution microscopy of surfaces, spectroscopic analysis of atoms, study of catalytic surfaces, etc. Target was to build a test-stand where our 500 MHz high power high frequency cavities and other high power structures can be tested using a 180 kW klystron amplifier which presently powers the SLS booster accelerator. The SLS booster accelerator which requires approximately 40 kW maximum power will then be powered by a 60 kW 500MHz SSPA. According to the estimations the SSPA should pay itself off with energy savings in a few years of operation. Other advantages offered by the solid-state technology would be the following: no need for high voltage, no other dedicated power supplies required (such as filament, focus coil, modulating anode, etc. in the case of tubes), no need of refurbishment of tubes, longer life time, simpler operation, no need for external circulator (since it is already included in each RF amplifier module), and redundancy that should allow the system to continue running in the case of failure of a single RF amplifier module.

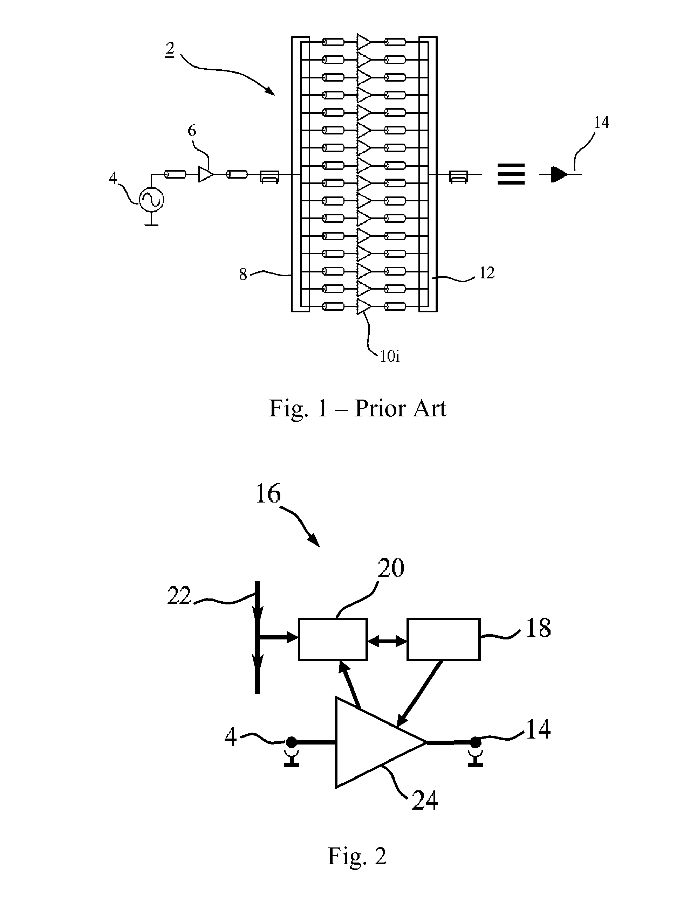

Due to the limited power that a single transistor can deliver, a combination of various amplifier units is used in the construction of large installations in order to reach very high RF output power. A typical configuration is shown in Fig 1.

Traditionally, the amplifier units are all factory trimmed to deliver the same output power and phase so that maximum combination efficiency can be obtained. Due to fluctuations in the production and adjustment processes, it is not practically possible that all amplifiers units deliver exactly the same output power amplitude and phase. The output power combiner will deliver at its output a combined total output power approximately equal to the average power of all amplifier units times the number of amplifier units, and with a phase delay which is, in the case of small phase spread among all amplifiers, approximately equal to the average phase delay of all amplifiers. The vectorial components of the RF output power which deviate in amplitude and phase delay from the average amplitude and the approximate average phase from each amplifier unit, which will be applied at any input of the combiner, will be reflected back from the combiner to all amplifier units. This reflected power will be dumped into the circulator loads and will be missing at the output of the power combiner consequently causing a deterioration (or degradation) of the combining efficiency.

The phase deviations have a reduced influence in the combining efficiency and can be minimized during the production process by, for example, in the case of MOSFET transistors, compensating for the variation in the transistor input capacitance. On the other hand, the RF power amplitude deviations may have strong influence in the combining efficiency. Due to fluctuations in the transistor fabrication process and also variations in the production of other devices, as well as, imprecision in the assembly and adjustment process of all amplifier units, fluctuations in gain, efficiency, input insertion loss and output RF power of each amplifier unit are in practice present and may be intensified if a large quantity of amplifier units is required to fulfill the system RF output power specifications.

And further, it is a good practice that the high power combined amplifier system foresees that some upgrade or increase in power may be requested from the users after some years of operation. In this case, some extra reserve in RF power must be included in the design of the system which means that in normal operation a well designed system will not be operating at its very maximum RF output power. Consequently, the system will have to be optimized for other RF output power levels lower than the specified maximum to operate at its best achievable efficiency at a given operating RF output power.

It is therefore an objective of the present invention to improve a solid-state RF power amplifier system that provides excellent performance while being operated at optimized conditions below maximum RF power amplification.

This objective is achieved according to the present invention by a solid-state power amplifier system, such as for use with accelerator applications, comprising:
a) a power input splitter unit;
b) a number of power amplifier modules, each being connected to the power input splitter unit;
c) an output power combiner receiving the output of each power amplifier module,
d) a system remote controller providing a target output power signal to the power amplifier modules;
   wherein
e) each power amplifier module comprises a single printed board circuitry, said printed board circuitry comprising an input balun, an input match, a number of transistors, like a pair of transistors in the case of a balanced configuration or a single transistor in the case of a single-ended configuration, an output match, an output balun and an output circulator;
f) said single printed board circuitry further comprising:
   i) at least one input power sensor comprising a coupling line being crosstalk-wise coupled with the input balun and/or the input match for providing an input power sensing signal;
   ii) at least one output power sensor comprising a coupling line being crosstalk-wise coupled with the output match and/or the output balun for providing an output power sensing signal;
   iii) a reflected power sensor comprising a circulator load being connected to the reflecting port of the circulator for generating an reflected power sensing signal;
g) each power amplifier module further comprising a microcontroller evaluating the input power sensing signal, the output power sensing signal and the reflected power sensing signal and optionally the transistor drain current and the transistor flange temperature; said microcontroller further controlling the transistor bias voltage, e.g. the gate-to-source voltage of a MOSFET transistor, and the drain voltage, e.g. the drain-to-source voltage of a MOSFET transistor, in order to match the effective forward power output with the target power output signal received from the system remote controller.

The computing power added to each amplifier modules enables therefore each amplifier module in order to optimize itself for the best operating conditions. An increase in reliability and efficiency at the target RF output power is the main objective for this local optimization. The microcontroller added to the amplifier modules provides the computing power required and performs the monitoring, control and optimization of the amplifier modules.

In a preferred embodiment of the present invention, the contact lines are disposed on the printed board directly juxtaposed to the input balun, the input match, the output match and output balun. Therefore, the proposed sensors can be included in the same printed circuit board as the one used for the amplifiers itself where typically the input and output baluns (in the case of a balanced configuration) and matching networks, as well as, other accessories are implemented. The presence of the sensors in the same printed board has advantages as the sensors may be added at parts of the board which are normally empty not affecting the final amplifier size and price.

The present invention is also valid for a single-ended (non-balanced) configuration where a single transistor is used as already mentioned above.

The single-ended (non-balanced) configuration or any other amplifier configuration type which requires matching structures and/or baluns are also covered by the present invention. This is also valid for any number of transistors used in a power amplifier module since each transistor will require input and output matching structures and baluns (in the case of a balanced configuration). The proposed sensors can be placed juxtaposed to any of the matching structures and baluns used, independently of the number of transistors and of the amplifier configuration type used in the design.

A further preferred embodiment provides for a design wherein the input power sensor, the output sensor and the reflected power sensor comprise a pair of diodes wherein the input power sensing signal, the output sensing signal and the reflected power sensing signal are proportional to the voltage difference generated by the respective pair of diodes. An optional attenuator may be used to provide voltage levels compatible with the levels accepted by the sensors and its diode pair used to convert the RF voltage present at the input balun, the input match, the output match, output balun and the circulator load into a DC voltage that can be digitized by the microcontroller.

Preferred embodiments of the present invention are hereinafter described in more detail with respect to the attached drawings which depict in:
- Figure 1: a schematic configuration for a combination of amplifier modules as RF power amplifier as known in the prior art;
- Figure 2: schematically an intelligent RF amplifier module;
- Figure 3: schematically divers power sensors implemented in an RF amplifier module;
- Figure 4: schematically an RF sensor measurement circuit for the sensing of the RF input power and/or the forward RF output power;
- Figure 5: schematically an RF sensor measurement circuit for the sensing of the RF reflected power;
- Figure 6: schematically a combined RF amplifier with intelligent amplifier modules as shown in Fig. 2;
- Figure 7: a section of a photography taken from the circuit board of an intelligent RF amplifier module with an RF input power sensor; and
- Figure 8: a photography of the view on the complete circuit board of an intelligent RF amplifier module.

As already mentioned earlier, Figure 1 shows exemplarily a known configuration of an RF power amplifier 3 which comprises an input current source 4, an input amplifier 6, an input power splitter unit 8, a number of RF power amplifier modules 10ᵢ (i is equal to 16 in the present example), an RF output power combiner 12 and RF power output 14.

Figure 2 shows schematically now the main difference between an RF power amplifier module 10ᵢ according to the prior art and an intelligent RF power amplifier module 16 according to the present invention. A power supply 18 that is controlled by a microcontroller 20 and the microcontroller 20 are added to each RF power amplifier module 16. The computing power added to each RF power amplifier module 16 enables therefore each amplifier module in order to optimize itself for the best operating conditions. An increase in reliability and efficiency at the target RF output power, which is transmitted via a computer network 22, is the main objective for this local optimization. The microcontroller 20 added to the amplifier module 16 provides the computing power required and performs the monitoring, control and optimization of each amplifier module 16 individually.

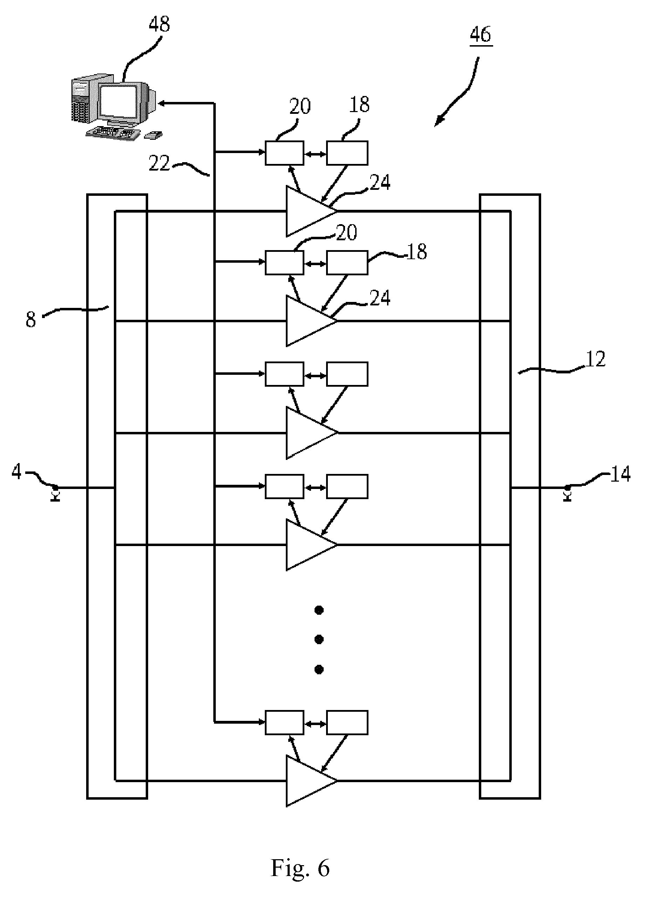

The target RF output power value which is required at the output of each amplifier module 16 is sent over the network 22 by a system remote microcontroller (computer) (shown in Figure 6) to the microcontrollers 20. The microcontroller software performs the calculations needed to obtain the best operating conditions of the RF amplifier (a transistor 24) to provide the RF output power required. Part of the calculation may also be performed by the remote computer. The transistor bias voltage, V_{gs} (gate-to-source voltage, in the case of a MOSFET transistor) and the drain voltage, V_{ds} (drain-to-source voltage, in the case of a MOSFET transistor) are provided by the power supply 18 also included in the amplifier module 16 and are set to give the best operating condition. Some parameters from the amplifier (transistor 24) are monitored in order for the optimization to be calculated. The parameters are: transistor drain current, I_{dd}, transistor flange temperature, forward RF output power, reflected RF output power and forward RF input power.

Each amplifier module 16, which is now called an intelligent RF amplifier unit, is then composed by the dedicated power supply 18, the computing system, which is presently based on the microcontroller 20 technology, and the RF power amplifier 24 itself, as shown in Fig. 2.

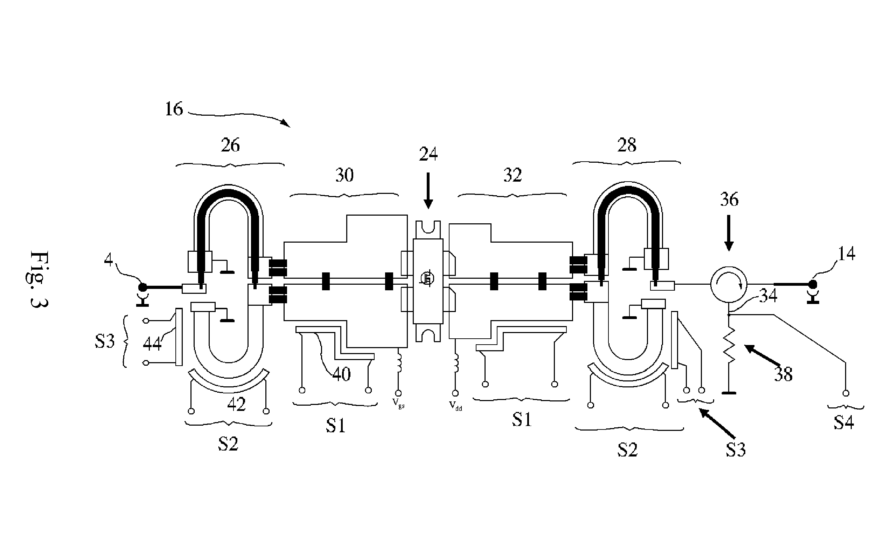

The types of sensors which are used to perform the power measurements, and which form part of the present invention, too, are shown in Fig 3.

Proposed sensors S1, S2, S3 and S4 are included in the same printed circuit board as the one used for the amplifier 24 where typically an input balun 26 and output baluns 28 (in the case of a balanced configuration) and an input 30 and an output match 32, as well as, other accessories are implemented. The presence of the sensors S1 to S4 in the same printed board has advantages as the sensors may be added at parts of the board which are normally empty not affecting the final amplifier size and price. The sensors S1, S2 and S3 are used for both input power and forward output power measurements. And the sensor S4 is used for reflected power measurements as it is attached to the reflected port 34 of a circulator 36. An attenuator may be used to provide voltage levels compatible with the levels accepted by sensors S1 to S4 used to convert the RF voltage present at a circulator load 38 into a DC voltage that can be digitized by the microcontroller 20.

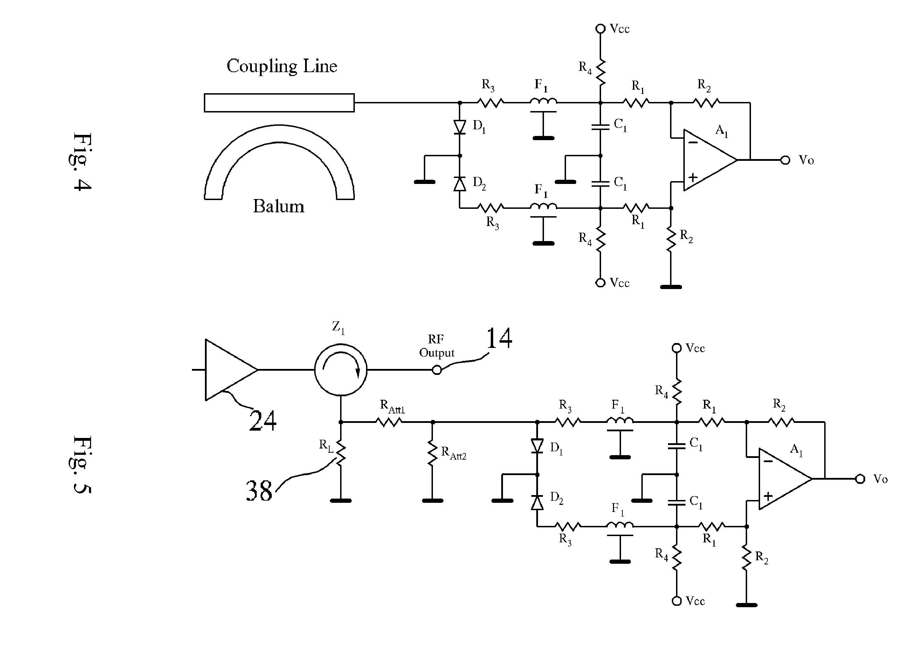

The circuit presented in Fig. 4 is used to acquire the measurements in the case of sensors S1, S2 and S3. A diode D1 is used to rectify the sensed RF voltage which crosstalks into coupling lines 40, 42 and 44 being disposed adjacent to the input balun 26, the input match 30, the output match 32 and the output balun 28. The operational amplifier Al calculates the difference of the voltages generated by the diode D1 and the dummy diode D2. With this technique the dynamic range and the temperature independence of the measurement are improved. The sensors S1 to S3 may also be terminated by a resistance if needed.

The circuit presented in Fig. 5 is used to acquire the measurements of sensor S4. The operation is similar to the one of the circuit previously described in Fig. 4.

During the adjustments of each amplifier module 16 a measurement set-up acquires all data from the amplifier module 16 under test. This information, which is stored in a computer data base, may also be included in the optimization process to obtain the best operating condition of each amplifier module 16 which will satisfy the required system RF output power at the output of the RF output power combiner 12. The here described "intelligent" amplifier module 16 therefore works as a remotely controlled independent entity.

Fig. 6 shows a final combined amplifier system 46 composed of various intelligent amplifier modules 16 which are combined following the typical configuration shown in Fig. 1. The amplifier modules 16 are all connected to a remote computer 48 over the computer network 22. The remote computer 48 is able to talk separately with each of the amplifier modules 16 composing the system 46. The remote computer 48 coordinates all amplifier modules 16 and gives the required target RF output power that each amplifier module 16 has to deliver. It also monitors and acquires all data from all amplifier modules 16 units for later presentation, participates in the optimization process and controls the interlock system to guarantee safe operation of the whole system 46.

The system RF output power is measured and acquired by the remote computer 48 which can then calculate the actual combining efficiency. During the proposed optimization the system RF input power may also be trimmed to help to bring each amplifier module 16 to its best operating condition. All the amplifier modules optimize themselves in real time and during normal operation without any deterioration in performance. The remote computer 48 performs further optimizations to bring the whole system 46 to the maximum combining and overall efficiencies achievable at the user required system RF output power.

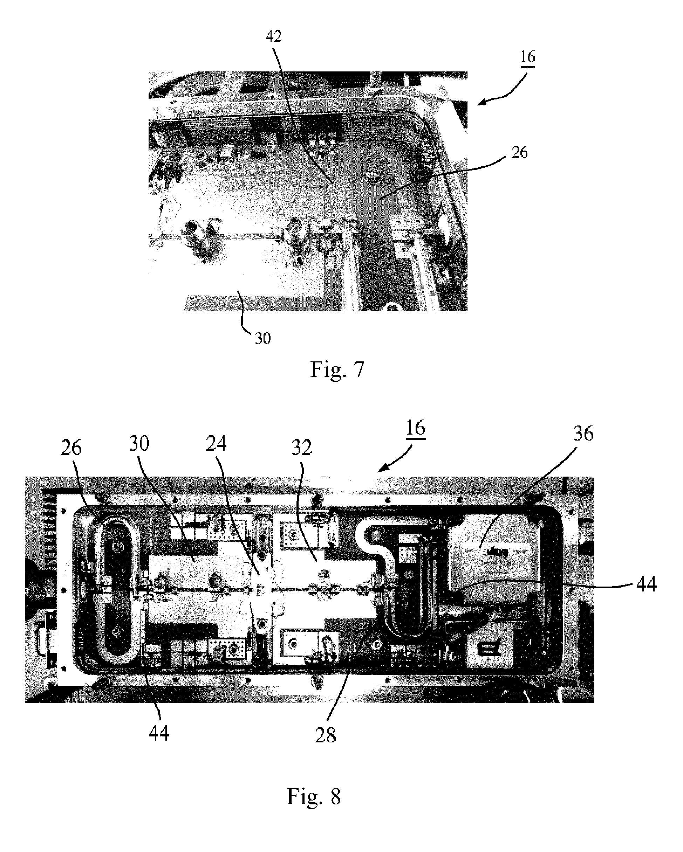

Fig. 7 shows a practical implementation of the sensor S3 and the corresponding sensor measurement circuit, as the one shown in Fig. 4, in the monitoring of the input forward RF power of a RF power amplifier module 16. The output of the sensor measurement circuit is connected to a monitoring printed circuit board which is assembled perpendicularly to the main RF printed circuit board and connects all monitoring signals to a filtered connector seen at right.

Fig. 8 shows an overall view of how all sensors, i.e., one sensor S3 for the input forward RF power measurement at right, one sensor S3 for the output forward RF power measurement at left, one sensor S4 for the output reflected RF power, and a temperature sensor area, using a bended printed circuit board assembled perpendicularly to the main RF printed circuit board, connected to the filtered monitoring connector at the very right. The bended printed circuit board can also carry extra signals as, for example, transistor biasing voltages.

In the present example, a balanced configuration using a pair of transistors per each circuit board has been explained. It has to be kept in mind that the single-ended (non-balanced) configuration or any other amplifier configuration type which requires matching structures and/or baluns are also covered by the present invention. This is also valid for any number of transistors used in a power amplifier module since each transistor will require input and output matching structures and baluns (in the case of a balanced configuration). Therefore, the number of transistor could be even three, four, five etc. transistors. The proposed sensors can be placed juxtaposed to any of the matching structures and baluns used, independently of the number of transistors and of the amplifier configuration type used in the design.

## Claims

1. A solid-state power amplifier system (46), such as for use with accelerator applications, comprising:
a) a input power splitter unit (8);
b) a number of power amplifier modules (16), each being connected to the power input splitter unit (8);
c) an output power combiner (12) receiving the output of each power amplifier module (16),
d) a system remote controller (48) providing a target output power signal to the power amplifier modules (16);
wherein
e) each power amplifier module (16) comprises a single printed board circuitry, said printed board circuitry comprising an input balun (26), an input match (30), a number of transistors, such as a pair of transistors (24) transistors in the case of a balanced configuration or a single transistor in the case of a single-ended configuration, an output match (32), an output balun (28) and an output circulator (36);
f) said single printed board circuitry further comprising:
i) at least one input power sensor (S1 to S3) comprising a coupling line (40 to 44) being crosstalk-wise coupled with the input balun (26) and/or the input match (30) for providing an input power sensing signal;
ii) at least one output power sensor (S1 to S3) comprising a coupling line (40 to 44) being crosstalk-wise coupled with the output match (32) and/or the output balun (28) for providing an output power sensing signal;
iv) a reflected power sensor (S4) comprising a circulator load (38) being connected to the reflecting port (34) of the circulator (36) for generating an reflected power sensing signal;
g) each power amplifier module (16) further comprising a microcontroller (20) evaluating the input power sensing signal, the output power sensing signal and the reflected power sensing signal and optionally the transistor drain current and the transistor flange temperature; said microcontroller (20) further controlling the transistor bias voltage, e.g. the gate-to-source voltage of a MOSFET transistor, and the drain voltage, e.g. the drain-to-source voltage of a MOSFET transistor, in order to match the effective forward power output with the target power output signal received from the system remote controller (48).

2. The system according to claim 1, wherein the contact lines (40 to 44) are disposed on the printed board directly adjacent to the input balun (26), the input match (30), the output match (32) and output balun (28).

3. The system according to claim 1 or 2, wherein the input power sensor (S1 to S3), the output sensor (S1 to S3) and the reflected power sensor (S4) comprise a pair of diodes (D1, D2) wherein the input power sensing signal, the output sensing signal and the reflected power sensing signal are proportional to the voltage difference generated by the respective pair of diodes (D1, D2).
